# EUROPEAN PATENT APPLICATION

(11) **EP 1 780 771 A1**
(43) Date of publication of application: **02.05.2007**
(21) Application number: 05753361.4
(22) Date of filing: 21.06.2005
(51) Int. Cl.: H01L 21/027, G03F 7/20, H01L 21/68

(54) **ALIGNING APPARATUS, ALIGNING METHOD, EXPOSURE APPARATUS, EXPOSURE METHOD AND DEVICE MANUFACTURING METHOD**

(30) Priority: 25.06.2004 JP 2004188113
(71) Applicant: NIKON CORPORATION, Tokyo 100-8831 (JP)
(72) Inventor: ARAI, Dai, NIKON CORPORATIION, Chiyoda-ku, Tokyo 1008331 (JP)
(74) Representative: HOFFMANN EITLE
(86) International application number: PCT/JP2005/011377
(87) International publication number: WO 2006/001282

(57) **Abstract**

An aligning apparatus.and the like are provided which can improve stage alignment accuracy during stage acceleration and suppress the generation of internal vibration of the stage to improve throughput. An aligning apparatus including a table part (43) with an aligning target object (W) placed thereon and movable at least in a uniaxial direction, a driving part that applies a driving force (F) to the table part (43) in the uniaxial direction, and a position measuring part (48) that measures a position in the uniaxial direction of the table part, wherein the table part (43) comprises actuators (96, 97), provided at one or more among somewhere between two points, one being a point of application of force (91) at which the driving force (F) is applied and the other being an aligning target point (92) upon which the aligning target object W is placed, somewhere between two points, one being a point to be measured (93) by the position measuring part and the other being the aligning target point (92), and somewhere between two points, one being the point of application of force (91) and the other being the measured point (93), to maintain relative positions between the respective two points substantially constant.

## Description

### Technical Field

The present invention relates to an aligning apparatus which moves at a highly accelerated speed while holding an object, and an exposure apparatus and the like having the same.
This application claims priority to Japanese Patent Application No. 2004-188113, filed on June 25, 2004, the contents of which are incorporated herein by reference.

### Background Art

In a lithography process for manufacturing semiconductor devices, liquid crystal display devices, etc., a step-and-repeat type reduction projection exposure apparatus (so-called stepper), a step-and-scan type scanning projection exposure apparatus (so-called scanning stepper) modified from this stepper, or the like is mostly used in a lithography process to transfer a pattern formed on a mask or reticle (hereinafter generically referred to as "reticle") through a projection optical system onto a photosensitive object, such as a wafer or a glass plate (hereinafter generically referred to as "wafer") the surface of which is coated with a resist or the like.
In a projection exposure apparatus such as a stepper, a stage device is provided, which moves with a reticle or wafer placed thereon precisely in a one-dimensional direction or two-dimensional directions within a plane (XY plane) under position servo control of a laser interferometer. Because of the need to achieve high throughput and high precision exposure, the stage device is required to achieve not only high acceleration and high speed but also high position control performance (including aligning performance).
To comply with these requirements, there are known a technique for absorbing, by counter mass, kinetic energy upon driving a movable stage to suppress reaction force or vibration, and a technique for suppressing right and left rotations about the center of gravity during movement of the movable stage using a gas static pressure bearing (so-called yaw bearing) (see Patent Document 1). The disclosure of the following publication is incorporated herein as part of this specification within a range of permission of the domestic laws and ordinances of the countries designated (or selected) in this international application
Patent Document 1: Japanese Patent Application Laid-Open No. 2004-80877

### Disclosure of the Invention

### Problem to be Solved by the Invention

However, the above-mentioned techniques are not necessarily enough for scanning type exposure apparatuses (step-and-scan type exposure apparatuses) for manufacturing electronic device chips in a 1G/4G bit class (with a minimum linewidth of 0.2 µm or less), which is expected to be produced on a large scale.
In other words, there arises a new problem that the movable stage itself deforms as the acceleration (driving -force) applied to the movable stage increases. Particularly, during acceleration of the movable stage, if distortion occurs among a region (point of application of force) at which the driving force is applied, a target object (measured point) to be measured by a laser interferometer, and a region (aligning target point) upon which the reticle or wafer is placed, the relative position between these members (two points) will vary. This not only makes it difficult to control the alignment of the movable stage accurately, but also makes the distortion occurring in the movable stage released after completion of acceleration to generate internal vibration. Therefore, the exposure process cannot be performed until the internal vibration of the movable stage is suppressed, and this could adversely affect the improvement of throughput.

The present invention has been made under the above circumstances, and it is an object thereof to provide an aligning apparatus, an aligning method, an exposure apparatus, an exposure method, and a device manufacturing method, which can improve stage alignment accuracy during stage acceleration and suppress the generation of internal vibration of the stage to improve throughput.

### Means for Solving the Problem

In order to solve the above problem, an aligning apparatus, an aligning method, an exposure apparatus, an exposure method, and a device manufacturing method according to the present invention employ the following means.
In an aligning apparatus (40) of the present invention including a table part (43) with an aligning target object (W) placed thereon and movable at least in a uniaxial direction, a driving part (46) that applies a driving force (F) to the table part (43) in the uniaxial direction, and a position measuring part (48) that measures a position in the uniaxial direction of the table part, the table part comprises actuators (86, 96, 97), provided in one or more among somewhere between two points, one being a point of application of force (91) at which the driving force is applied and the other being an aligning target point (92) upon which the aligning target object W is placed, somewhere between two points, one being a point to be measured (93) by the position measuring part and the other being the aligning target point, and somewhere between two points, one being the point of application of force and the other being the measured point, to maintain relative positions between the respective two points substantially constant.
According to this invention, when the driving part applies the driving force to the table part on which the aligning target object is placed, since the relative positions between the point of application of force and the aligning target point, between the measured point and the aligning target point, and between the point of application of force and the measured point are maintained constant, respectively, the alignment of the aligning target object can be performed precisely. Further, since distortion hardly occurs between the two points during movement of the table part, the internal vibration of the table part caused by releasing the distortion can be prevented.

If the table part (43) includes an actuator (87) that maintains the relative position between a predetermined member (82) in the table part and the point of application of force (91) substantially constant, the occurrence of distortion in the table part can be suppressed by keeping the relative position between the predetermined member and the point of application of force constant, thereby preventing the occurrence of internal vibration.
Further, if the actuators (86, 87, 96, and 97) are driven upon acceleration and/or deceleration of the table part (43), the occurrence of internal vibration in the table part can be prevented even if a large driving force is applied.
Further, if the actuators (86, 87, 96, and 97) are to provide a change in rigidity between the two points, respectively, since the occurrence of distortion in the table part can be suppressed by increasing the rigidity between the two points in the table part, the generation of internal vibration in the table part caused by releasing the distortion can be prevented.
Further, if the actuators (86, 87, 96, and 97) are to exert a predetermined force between the two points, respectively, since the occurrence of distortion in the table part can be prevented by exerting substantially the same magnitude of force in a direction opposite to that of the driving force applied between the two points during movement of the table part, the internal vibration of the table part caused by releasing the distortion can be prevented.
As the actuators (96 and 97), for example, piezoelectric actuators (86 and 87) can be used to make it easy to implement the above structure.
In a different aspect of the present invention, an aligning apparatus comprises a table part (43) that places an object (W) thereon, and a drive unit (46) that moves the table part, wherein a relative position between a point of application of force (91) in the table part at which a driving force (F) of the drive unit is applied and an aligning target point (92) in the object is maintained substantially constant.

An aligning method of the present invention is to place an aligning target object (W) on a table part (43) movable at least in a uniaxial direction and measure a position in the uniaxial direction of the table part while applying a driving force (F) to the table part in the uniaxial direction so as to move the aligning target object to a predetermined position, wherein upon acceleration and/or deceleration of the table part, one or more relative positions between a point of application of force (91) in a table part at which the driving force is applied and an aligning target point (92) upon which the aligning target object is placed, between a point (93) to be measured by a position measuring part and the aligning target point, and between the point of application of force and the measured point are maintained substantially constant.
According to this invention, when a driving part applies the driving force to the table part on which the aligning target object is placed, since the relative positions between the point of application of force and the aligning target point, between the measured point and the other being the aligning target point, and between the point of application of force and the measured point are maintained constant, respectively, the alignment of the aligning target object can be performed precisely. Further, since distortion hardly occurs between the two points during movement of the table part, the internal vibration of the table part caused by releasing the distortion can be prevented.

If the relative position between a predetermined member (82) in the table part (43) and the point of application of force (91) is maintained substantially constant concurrently, the occurrence of distortion in the table part can be suppressed by keeping the relative position between the predetermined member and the point of application of force constant, thereby preventing the generation of internal vibration.
Further, if rigidity between two points is changed, since the occurrence of distortion in the table part can be suppressed by increasing the rigidity between the two points in the table part, the generation of internal vibration in the table part caused by releasing the distortion can be prevented.
Further, if a predetermined force is exerted between two points, since the occurrence of distortion in the table part can be prevented by exerting substantially the same magnitude of force in a direction opposite to that of the driving force applied between the two points during movement of the table part, the internal vibration of the table part caused by releasing the distortion can be prevented.
In a different aspect of the present invention, an aligning method is to place an object (W) on a table part (43) and move the table part by a drive unit (46), wherein the relative position between a point of application of force (91) in the table part at which a driving force (F) of the drive unit is applied and an aligning target point (92) in the object is maintained substantially constant at least during the movement of the table part.

In an exposure apparatus (EX) of the present invention including a mask stage (20) for holding a mask (R) and a substrate stage (40) for holding a substrate (W) to expose a pattern (PA) formed on the mask onto the substrate, the aligning apparatus of the present invention is used for at least either of the mask stage (20) and the substrate stage (40).
According to this invention, not only can the alignment of the mask or the substrate be performed with high precision, but also the generation of internal vibration can be prevented upon acceleration or deceleration of the stage, enabling efficient alignment of the mask and the substrate.
Another exposure apparatus (EX) of the present invention is to form a predetermined pattern on a substrate (W), wherein the aligning apparatus of the present invention is used for aligning the substrate.

An exposure method of the present invention is to align a mask (R) placed on a mask stage (20) and a substrate (W) placed on a substrate stage (40) and expose a pattern (PA) formed on the mask onto the substrate,
wherein the aligning method of the present invention is used as at least either a mask aligning method or a substrate aligning method.
According to this invention, not only can the alignment of the mask or the substrate be performed with high precision, but also the generation of internal vibration can be prevented upon acceleration or deceleration of the stage, enabling efficient alignment of the mask and the substrate.

Another exposure method of the present invention is to form a predetermined pattern on a substrate (W),
wherein the aligning method of the present invention is used for aligning the substrate.
According to this invention, a fine pattern can be produced with high precision and high throughput.
In a device manufacturing method of the present invention, the exposure apparatus (EX) or the exposure method is used.

### Effects of the Invention

According to the present invention, the following effects can be obtained.
In the aligning apparatus and the aligning method of the present invention, when the driving force is applied to the table part, the relative positions between the point of application of force and the aligning target point, between the two points of the measured point and the aligning target point, and between the point of application of force and the measured point are maintained constant, respectively. This makes it possible not only to improve alignment accuracy in the table part but also to prevent internal vibration in the table part.
In the exposure apparatus and the exposure method of the present invention, since the alignment of the mask or the substrate can be performed with high precision without the need to spend unnecessary waiting time, an exposure process for fine patterns can be performed with high throughput.
In the device manufacturing method of the present invention, since a fine pattern can be produced with high precision and high throughput, high-performance, low-price devices can be obtained.

### Brief Description of the Drawings

[FIG. 1] It is a schematic view illustrating the structure of a preferred embodiment of an exposure apparatus EX.
[FIG. 2] It is an enlarged schematic view of an XY table 43.
[FIG. 3A] It is a conceptual diagram illustrating operation upon applying a driving force F to the XY table 43.
[FIG. 3B] It is a conceptual diagram illustrating the operation upon applying the driving force F to the XY table 43.
[FIG. 3C] It is a conceptual diagram illustrating the operation upon applying the driving force F to the XY table 43.
[FIG. 4A] It is a schematic view illustrating operation upon applying the driving force F to a conventional XY table 43'.
[FIG. 4B] It is a schematic view illustrating the operation upon applying the driving force F to the conventional XY table 43'.
[FIG. 4C] It is a schematic view illustrating the operation upon applying the driving force F to the conventional XY table 43'.
[FIG. 5A] It is a conceptual diagram illustrating the operation upon applying the driving force F to the conventional XY table 43'.
[FIG. 5B] It is a conceptual diagram illustrating the operation upon applying the driving force F to the conventional XY table 43'.
[FIG. 5C] It is a conceptual diagram illustrating the operation upon applying the driving force F to the conventional XY table 43'.
[FIG. 6] It is a schematic view illustrating an alternative to the XY table 43.
[FIG. 7] It is a flowchart illustrating an example of a microdevice manufacturing process.
[FIG. 8] It is a chart illustrating an example of a detailed process of step S13 for semiconductor devices.

### Description of Reference Numerals and Symbols

20 reticle stage (mask stage); 40 wafer stage (aligning apparatus, substrate stage); 43 XY table (table part); 46 driving part; 48 laser interferometer (position measuring part); 82 lower member (predetermined member); 86, 87 piezoelectric actuator; 91 point of application of force; 92 aligning target point; 93 measured point; 96, 97 actuator; F driving force; PA pattern; R reticle (mask); W wafer (aligning target object, substrate); EX exposure apparatus.

### Best Mode for Carrying Out the Invention

Embodiments of an aligning apparatus, an aligning method, an exposure apparatus, an exposure method, and a device manufacturing method of the present invention will now be described with reference to the drawings.

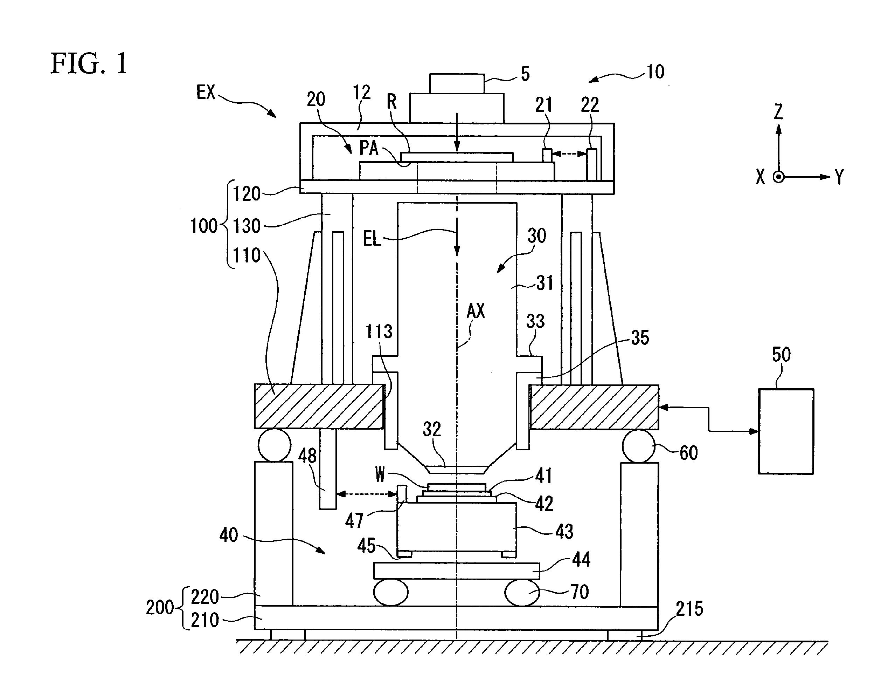

FIG. 1 is a schematic view illustrating the structure of a preferred embodiment of an exposure apparatus EX of the present invention.
The exposure apparatus EX is a step-and-scan type scanning exposure apparatus, that is, a so-called scanning stepper, which transfers a pattern PA formed on a reticle R to each shot area on a wafer W through a projection optical system 30 while synchronously moving the reticle (mask) R and the wafer (aligning target object, substrate) W in one-dimensional direction.
The exposure apparatus EX is equipped with an illumination optical system 10 for illuminating the reticle R with exposure light EL, a reticle stage 20 for holding the.reticle R, the projection optical system 30 for projecting the exposure light EL irradiated from the reticle R onto the wafer W, a wafer stage 40 for holding the wafer W, and a control device 50 for centralized control of the exposure apparatus EX.
These components are supported in a main frame 100 or on a base frame 200 through vibration damping units 60, 70 and the like.
It is assumed in the following description that the direction that coincides with the optical axis AX of the projection optical system 30 is a Z axis direction, the synchronous moving direction (scanning direction) of the reticle R and the wafer W in a plane perpendicular to the Z axis direction is a Y axis direction, and the direction (non-scanning direction) perpendicular to the Z axis direction and the Y axis direction is an X axis direction. In addition, rotation directions about the X axis, the Y axis, and the Z axis are θX, θY, and θZ directions, respectively.

The illumination optical system 10 is to illuminate with the exposure light EL the reticle R supported by the reticle stage 20, and includes (though not shown) an exposure light source, an optical integrator for uniformizing the illumination intensity of a-light flux irradiated from the exposure light source, a condenser lens for condensing the exposure light EL from the optical integrator, a relay lens system, a variable field stop for setting an illumination area on the reticle R with the exposure light EL in the form of a slit, etc.
As the exposure light EL irradiated from the illumination optical system 10, an emission line (such as g-line, h-line, or i-line) in a ultraviolet region irradiated from a mercury lamp, far ultraviolet light (DUV light) such as KrF excimer laser light .(248 nm wavelength), or vacuum ultraviolet light (VUV light) such as ArF excimer laser light (193 nm wavelength) is used.
A laser beam irradiated from a light source 5 is incident into the illumination optical system 10 in which the cross section of the laser beam is shaped into a slit or rectangular (polygonal) shape and its illumination distribution is made substantially uniform. The illumination light (exposure light) EL having the substantially uniform illumination distribution is then irradiated onto the reticle R.
This illumination optical system 10 is supported by an illumination system supporting member 12 fixed on the upper surface of a second support board 120 that forms part of the main frame 100.

The reticle stage (mask stage) 20 is to make two-dimensional movements in a plane, that is, in an XY plane, orthogonal to the optical axis AX of the projection optical system 30 and fine rotations in the θZ direction while supporting the reticle R. The reticle stage 20 includes (though not shown) a reticle fine movement stage for holding the reticle R, a reticle coarse movement stage moving integrally with the reticle fine movement stage in the Y axis direction as the scanning direction with a predetermined stroke, a liner motor for moving these stages, etc. A rectangular opening is formed in the reticle fine movement stage, and a reticle suction-holding mechanism provided around the periphery of the opening holds the reticle by vacuum suction or the like.
A moving mirror 21 is provided on the reticle stage 20. A laser interferometer 22 is also provided at a position opposite to the moving mirror 21. The position in the two-dimensional directions and rotation angle of the reticle R on the reticle stage 20 are measured by the laser interferometer 22 in real time, and the measurement results are output to the control device 50. Then, based on the measurement results, the control device 50 drives the liner motor or the like to align the reticle R or the like supported by the reticle stage 20.
This reticle stage 20 is supported through unillustrated non-contact bearings (for example, gas static pressure bearings) in a floating manner over the upper surface of the second support board 120 that forms part of the main frame 100.

The projection optical system 30 is to projection-expose the pattern PA of the reticle R onto the wafer W at a predetermined projection magnification β, and is composed of a plurality of optical elements including an optical element 32 provided at the front end (lower end) on the wafer W side. These optical elements are supported in a body tube 31. In the embodiment, the projection optical system 30 is a reduction system in which the projection magnification β is, for example, 1/4 or 1/5. Note that the projection optical system 30 may be of a full-scale (1:1) or enlargement type.
A flange 33 is provided around the outer wall of the body tube 31, and inserted into a cylindrical sensor supporting frame 35 having a flange. Further, the body tube 31 and the sensor supporting frame 35 are inserted into and supported by a hole part 113 provided in a first support board 110 that forms part of the main frame 100 The first support board 110 is supported almost horizontally through the vibration damping unit 60 over the base frame 200.
The sensor supporting frame 35 is a member for supporting sensors and the like such as an autofocus sensor. Further, an unillustrated kinematic mount is provided between the first support board 110 and the sensor supporting frame 35 to enable tilt angle adjustment of the projection optical system 30.

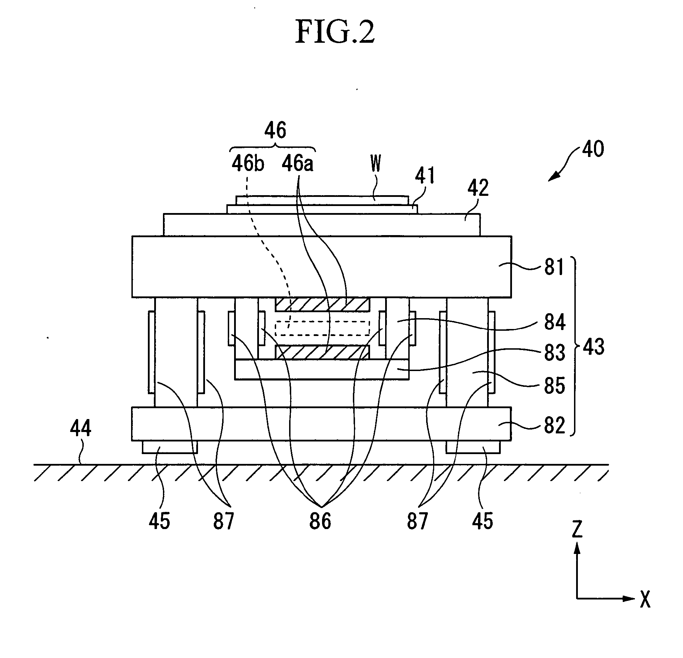

The wafer stage (aligning apparatus, substrate stage) 40 is to make two-dimensional movements in the XY plane-and fine rotations in the θZ direction while supporting the wafer W. The wafer stage 40 includes a wafer holder 41 for holding the wafer W, a Z table 42 for finely drive the wafer holder 41 with three degrees of freedom in the Z axis direction, the θX direction, and the θY direction in order to perform leveling and focusing on the wafer W, aw XY table (table part) 43 for continuously moving the Z table 42 in the Y axis direction while step-moving in the X axis direction, a wafer bed 44 for movably supporting the XY table 43 in the XY plane, a driving part 46 (see FIG. 2) composed of a liner motor or the like for moving the Z table 42 and the XY table 43 integrally in parallel, etc.
Further, a moving mirror 47 is provided on the Z table 42, and a laser interferometer (position measuring part) 48 is provided at a position opposite to the moving mirror 47. The position in the two-dimensional directions and rotation angle of the wafer W on the wafer stage 40 are measured by the laser interferometer 48 in real time, and the measurement results are output to the control device 50. Then, based on the measurement results from the laser interferometer 48, the control device 50 drives the liner motor or the like to align the wafer W or the like supported by the wafer stage 40.
A plurality of air pads 45 as the non-contact bearings are fixed on the bottom surface of the XY table 43, and these air pads 45 allow the XY table 43 to be supported in a floating manner over the wafer bed 44 with a clearance of, for example, about several microns. Further, the wafer bed 44 is supported almost horizontally through the vibration damping unit 70 above a support board 210 of the base frame 200.

The control device. 50 centrally controls the exposure apparatus EX, and includes a storage part for recording various information, an input/output part, etc. as well as an operation part for various computation and control operations.
Then, for example, based on the detection results from the laser interferometers 22 and 48, the control device 50 controls the positions of the reticle R and the wafer W and repeats an exposure operation to transfer an image of the pattern PA formed on the reticle R to shot areas on the wafer W.

FIG. 2 is an enlarged schematic view of the XY table 43.
The XY table 43 is composed of an upper member 81 for placing the Z stage thereon, a lower member (predetermined member) 82 on the underside of which the air pads 45 are arranged, a mover securing member 83 for securing part of movers 46a in the driving part 46, etc.
The upper member 81 and the lower member 82 are plate-like members, respectively, and coupled together through a plurality of coupling members 85.
The mover securing member 83 is arranged between the upper member 81 and the lower member 82, and coupled to the upper member 81 through a plurality of coupling members 84. The movers 46a in the liner motor (driving part 46) for moving the XY table 43 in the X axis direction or the Y axis direction are arranged on the lower surface of the upper member 81 and the upper surface of the mover securing member 83 in such a manner to oppose to each other. A stator 46b is arranged between the pair of movers 46a and coupled to the wafer stage bed 44 or the support board 210.
The coupling members 84 and 85 are quadrangular column-like members elongated in the Z direction, respectively. Therefore, they have lower rigidity in the X and Y directions than the upper member 81, the lower member 82, and the mover securing member 83. Then; piezoelectric actuators 86 and 87 are attached to the sides of the coupling members 84 and 85 in the X and Y directions, respectively. Among the piezoelectric actuators 86 and 87 attached to the four sides, pairs of piezoelectric actuators 86 and 87 opposite to each other expand and contract differentially in accordance with instructions from the control device 50 in a manner as will be described later. For example, when the piezoelectric actuators 86 attached to the sides of the coupling members 84 in the +X direction expand, the piezoelectric actuators 86 attached to the sides in the -X direction contract by the same amount. Thus, since the piezoelectric actuators 86 and 87 attached on the opposite sides expand and contract differentially, the coupling members 84 and 85 can be minutely deformed to be bent in the X direction. Similarly, the piezoelectric actuators 86 and 87 attached on the opposite sides in the Y direction are operated differentially to each other so that the coupling members 84 and 85 can be minutely deformed to be bent in the Y direction.

The main frame 100 is composed of the first support board 110 for supporting the projection optical system 30, the second support board 120 for supporting the reticle stage 20 and the like arranged above the projection optical system 30, and a plurality of columns 130 standing between the first support board 110 and the second support board 120. As mentioned above, the hole part 113 having a diameter slightly larger than the outer diameter of the cylindrical projection optical system 30 is formed in the first support board 110. Note that the first support board 110 or the second support board 120 and the plurality of columns 130 may be coupled by fastening means or the like, or they may be formed integrally.
Then, as mentioned above, the main frame 100 is supported above the base frame 200 through the vibration damping unit 60.

The base frame 200 is composed of the support board 210 for supporting the wafer stage 40 through the vibration damping unit 70 over the upper surface thereof, and the plurality of columns 220 standing on the support board 210 to support the main frame 100 through the vibration damping unit 60. The support board 210 and the columns 220 may be coupled by fastening means or the like, or they may be integrally formed.
The base frame 200 is installed almost horizontally on the floor in a clean room through foot parts 215.

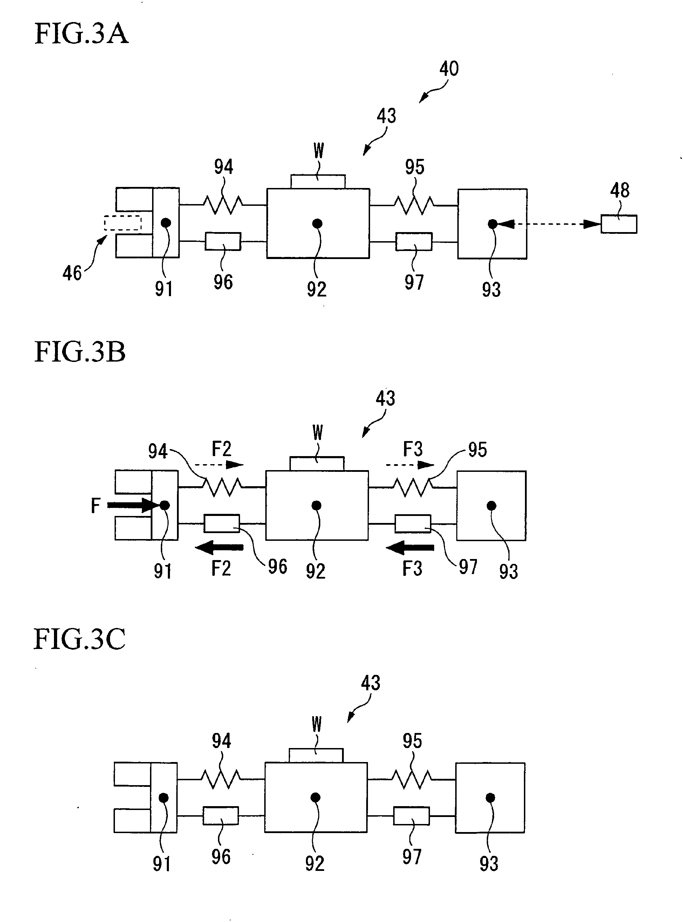

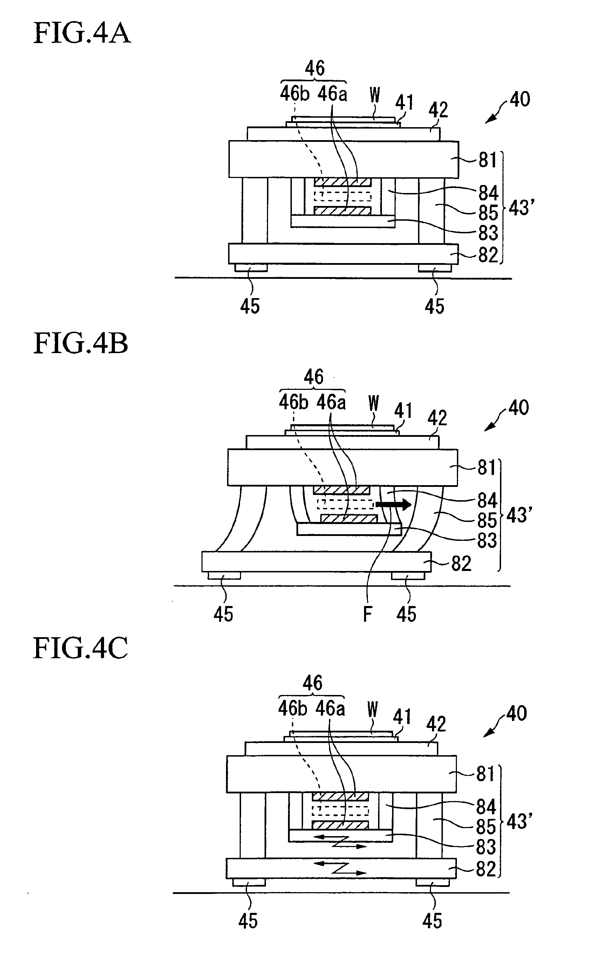

The following describes an exposure method for exposing an image of the pattern PA of the reticle R onto the wafer W using the above-mentioned exposure apparatus EX. FIGS. 3A to 3C are schematic views illustrating operation upon applying the driving force F to the XY table 43. FIGS. 4A to 4C and FIGS. 5A to 5C are schematic views and conceptual diagrams in case of a conventional XY table 43'.
First, the reticle R is loaded on the reticle stage 20 and the wafer W is loaded on the wafer stage 40. Then, after setting various exposure conditions, predetermined preliminary work is done under the control of the control device 50, such as reticle alignment using a reticle microscope and an off-axis alignment sensor, or the like (both not shown), baseline measurement using an alignment sensor, etc. After that, fine alignment (Enhanced Global Alignment (EGA) etc.) of the wafer W is completed using the .alignment sensor to determine the alignment coordinates of a plurality of shot areas on the wafer W.
After completion of the preliminary work for exposure of the wafer W, the control device 50 moves the wafer stage 40 to an acceleration start position (scanning start positron) for exposure of a first shot (first shot area) of the wafer W while monitoring the measured values from the laser interferometer 48 on the wafer W side based on the alignment results .
Then, the control device 50 starts scanning of the reticle stage 20 and the wafer stage 40 in the Y axis direction, and when the reticle stage 20 and the wafer stage 40 reach their target scanning speeds, respectively, an pattern area of the reticle R is irradiated with the exposure light EL to start scanning exposure.
Then, different pattern areas of the reticle R are sequentially illuminated with the exposure light EL, and after completion of illumination of all the pattern areas, the scanning exposure of the first shot area on the wafer W is completed, resulting in reduction transfer of the pattern PA of the reticle R to a resist layer in the first shot area on the wafer W through the projection optical system 30,
After completion of the scanning exposure of this first shot area, the control device 50 moves the wafer stage 40 in the X and Y axis directions in a step-by-step fashion to an acceleration start position for exposure of a second shot area. In other words, a stepping operation between shots is performed. Then, scanning exposure is performed on the second shot area in the manner as mentioned above.
Thus, the scanning exposure of a shot area on the wafer W and the stepping operation for exposure of the next shot area are repeatedly performed to transfer the pattern PA of the reticle R sequentially to all exposure target shot areas on the wafer W.
Then, such processing, is repeated to perform exposure of a plurality of wafers W.

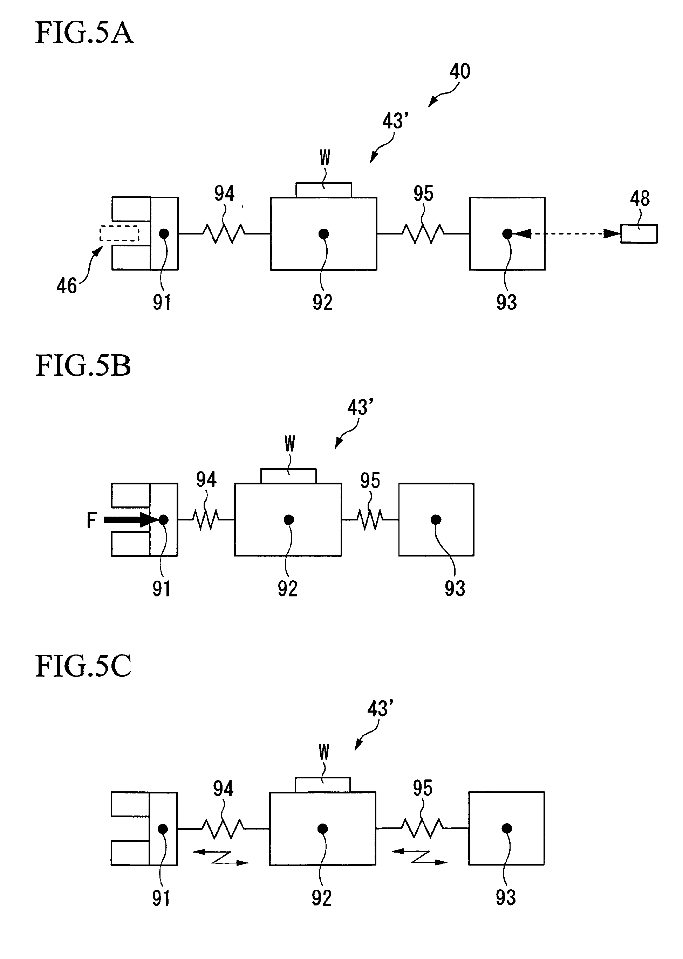

As described above, although the wafer stage 40 repeats acceleration and deceleration during the exposure process, since the acceleration absolute value is becoming larger year by year to improve throughput, the driving force (acceleration) applied to the XY table 43 is also becoming larger.
If a large driving force (acceleration) is applied to the XY table 43, distortion occurs in a portion low (weak) in rigidity in case of the conventional XY table 43' . Specifically, as shown in FIGS. 4A and 4B, when a large driving force F is applied to the right on the paper surface, distortion (minute deformation) occurs in the portion weak in rigidity in the XY directions, that is, in the coupling members 84 in the XY table 43'. When schematically representing this, a spring element 94 resides as shown in FIG. 5A between two points of a member (point of application of force) 91 at which the driving force F is applied and a member (aligning target point) 92 upon which the wafer W is placed, and when the large driving force F is applied at the point of application of force 91 in the XY table 43 as shown further in FIG. 5B, the spring element 94 is compressed. Then, when the acceleration or deceleration is completed and the application of the driving force F is stopped, distortion occurring in the spring element 94 is released, resulting in the generation of vibration (internal vibration) in the XY table 43 as shown in FIG. 5C.
Therefore, even if a target scanning speed is achieved during acceleration from a stopped state to start exposure, it is necessary to wait until the internal vibration that has occurred in the XY table 43' is suppressed (see FIG. 4C) before the start of irradiation of exposure light in order to prevent poor exposure. This causes unnecessary waiting time, though a short time, during the exposure process, resulting in a reduction in throughput.

Similarly, suppose that a member between a member (measured point) 93 to which the moving mirror 47 for measuring the position of the wafer W is fixed and the aligning target point 92 has low rigidity. Since a spring element 95 resides between the aligning target point 92 and the measured point 93, if a large driving force F is applied at the point of application of force 91 in the XY table 43', the spring element 95 will be compressed. Then, when the acceleration or deceleration is completed and the application of the driving force F is stopped, distortion occurring in the spring element 95, like in the spring element 94, is released, resulting in the generation of vibration (internal vibration) in the XY table 43'.
Thus, when misalignment in the relative position of the aligning target point 92 and the measured point 93 occurs, the alignment of the wafer W as the-aligning target object becomes inaccurate. Further, misalignment in the relative position of the point of application of force 91 and the measured point 93 makes the alignment control system unstable. Therefore, like in the above case, it is necessary to wait until the internal vibration that has occurred in the XY table 43' is suppressed before the start of the exposure process in order to prevent poor exposure.

In contrast, in the XY table 43 of the embodiment, the spring element 94, 95 and the actuators 96, 97 are arranged in parallel between the point of application of force 91 and the aligning target point 92 as shown in FIG. 3A. In other words, it means that the piezoelectric actuators 86 are attached to the coupling members 84.
Then, when a large driving force F is applied to the point of application of force 91 in the XY table 43, the actuators 96 and 97 are driven at the same instant when the driving force F is applied. Specifically, the piezoelectric actuators 86 attached to the sides of the coupling members 84 orthogonal to the moving direction is operated differentially to each other to minutely deform in order to restore the coupling members 84 distorted by the application of the driving force F to the original shape. This can suppress the deformation (bending) of the coupling members 84 even if the large driving force F is applied. In other words, as shown in FIG. 3B, the actuator 96 is driven to generate a force (-F2), having substantially the same magnitude as force F2 applied between the point of application of force 91 and the aligning target point 92, in a direction opposite to that of F2. Similarly, the actuator 97 is driven to generate a force (-F3), having substantially the same magnitude as force F3 applied between the aligning target point 92 and the measured point 93, in a direction opposite to that of F3.
If the masses of the members in which the point of application of force 91, the aligning target point 92, and the measured point 93 exist are represented as m1, m2, and m3, respectively, and the acceleration is represented as α, the driving force F applied to the point of application of force 91 is F=(m1+m2+m3)×α. Then, driving force F2=.(m2+m3)×α is transmitted between the point of application of force 91 and the aligning target point 92, and driving force F3=m3×α is transmitted between the aligning target point 92 and the measured point 93. Thus, as-mentioned above, the actuators 96 and 97 generate -F2 force between the point of application of force 91 and the aligning target point 92 and -F3 force between the aligning target point 92 and the measured point 93 (note that -F2 and -F3 are forces in the direction opposite to that of the driving force F, which are indicated by solid arrows in FIG. 3B). This increases apparent rigidities between the point of application of force 91 and the aligning target point 92 and between aligning target point 92 and the measured point 93 during acceleration of the XY table 43, thereby suppressing internal vibration. In other words, the relative positions are maintained constant without their deformation.
Then, the driving of the actuators 96 and 97 is stopped when the application of the driving force F to the XY table 43 is completed, that is, upon completion of acceleration. This continuously maintains the relative positions constant, as shown in FIG. 3C, between the point of application of force 91 and the aligning target point 92, and between the aligning target point 92 and the measured point 93. Note:here that the relative position between the point of application of force 91 and the measured point 93 is also maintained constant in an indirect manner, thus preventing the occurrence of distortion and hence the generation of internal vibration.
Since the occurrence of distortion in the XY table 43 is suppressed, the alignment control of the aligning target point 92, that is, of the wafer W can be performed with high precision. Further, since internal vibration is prevented, the exposure light can be irradiated to start exposure at the same instant when acceleration is completed. This can eliminate the unnecessary waiting time and hence improve throughput.

The same operation can-be performed upon deceleration as well as upon acceleration. Upon acceleration again immediately after deceleration to perform the next exposure or the like, since internal vibration is prevented, the exposure can be performed while maintaining the alignment accuracy of the wafer W.
The present invention is also applicable to the reticle stage 20 as well as the XY table 43.
According to the present invention, since the distance between the aligning target point 92 and the measured point 93 is maintained constant even during acceleration or deceleration of the XY table 43, the alignment of the wafer (substrate) W can be done accurately. Therefore, in case of the above-mentioned scanning type exposure, the exposure operation may be performed on the wafer-W not only when the XY table 43 holding the wafer W thereon is moving at constant speed, but also during acceleration or deceleration. In this case, in case of scanning exposure, irradiation of exposure light to the wafer W is started before the XY table 43 or the reticle stage 20 reaches its target scanning speed after acceleration. Then, the irradiation of the exposure light Y to the wafer W is maintained while the XY table 43 or the reticle stage 20 is moving at the constant speed as its target scanning speed and until the XY table 43 or the reticle stage 20 reaches arbitrarily set timing during deceleration after its constant speed movement. This makes it possible to further improve throughput. In this case, it can be set that the irradiation of the exposure light to the wafer W is performed while the control device 50 is driving the actuators 96 and 97. The irradiation of the exposure light to the substrate W may be performed only during acceleration and constant speed movement of the substrate W, or only during constant speed movement and deceleration. Exposure methods for performing scanning exposure during acceleration and deceleration of the wafer (substrate) are disclosed, for example, in US Patent 5,995,203 and Japanese Patent Application Laid-Open No. 07-57985. The disclosure of the above US patent and publication are each hereby incorporated by reference in its entirety to the extent permitted the national laws and regulations of designated states (or selected states) designated by the present international patent application.

Further, actuators may be provided between the point of application of force 91 and another member in the XY table 43 to improve rigidity therebetween in order to prevent internal vibration. In other words, the piezoelectric actuators 87 are attached to the coupling member 85 (see FIG. 2) and the piezoelectric actuators 87 are operated in the manner as mentioned above so that the occurrence of distortion in the coupling member 85 can be suppressed.
Thus, since the actuators (piezoelectric actuators 87) are provide between the point of application of force 91 and the other member (coupling member 85) to apply a force opposite in direction to the force transmitted between these two points upon application of the driving force F to the XY table 43, apparent rigidity can be so improved that the relative position between the two points can be maintained constant, thereby suppressing the occurrence of distortion between the two points, and hence preventing the generation of internal vibration.

In the foregoing embodiment,-the spring elements,94, 95 and the actuators 96, 97 are arranged in parallel between the point of application of force 91 and the aligning target point 92, and between the aligning target point 92 and the measured point 92, respectively, but only the actuators 96, 97 may reside between these two points respectively. In other words; the members weak in rigidity such as the coupling members 84 may be all constructed of piezoelectric actuators. For example, in the XY table 43 as shown in FIG. 2, the coupling members 84, 85 themselves that form parts of the XY table 43 may be constructed of piezoelectric actuators (piezoelectric elements). Further, structural elements other than the coupling members 84, 85 may also be replaced with the piezoelectric actuators.

The piezoelectric actuators may be of either a laminated type or a bimorph type.
Further, the actuators 96, 97 do not necessarily need to have high rigidity under normal conditions. This is because the apparent rigidity can be increased as long as they can generate a large force opposite in direction to and competitive with the force applied between two members (two points). Therefore, they may be non-contact type electromagnetic actuators or the like.

Note that the operation procedure, the various shapes and combinations of respective members, etc. illustrated in the foregoing embodiment are just illustrative examples, and various changes can be made based on the process conditions and design requirements without departing from the spirit and scope of the present invention. For example, the present invention includes the following changes:

In the foregoing embodiment, although the description is made of the case that the relative between the point of application of force 91 and the aligning target point 92, and between the aligning target point 92 and the measured point 93 are kept constant to keep the relative position between the point of application of force 91 and the measured point 93 constant in an indirect manner, the present invention is not limited thereto. Of course, actuators can be arranged directly between the point of application of force 91 and the measured point 93.
Further, only the relative position between the point of application of force 91 and the aligning target point 92 may be kept constant without providing the measured point 93. For example, if the driving part 46 itself generates a driving force like a pulse motor based on information related to the target position of the aligning target point 92, the aligning target point 92 can be positioned accurately as long as the relative position between the point of application of force 91 at which the driving force of the pulse motor is applied and the aligning target point 92 is substantially constant.

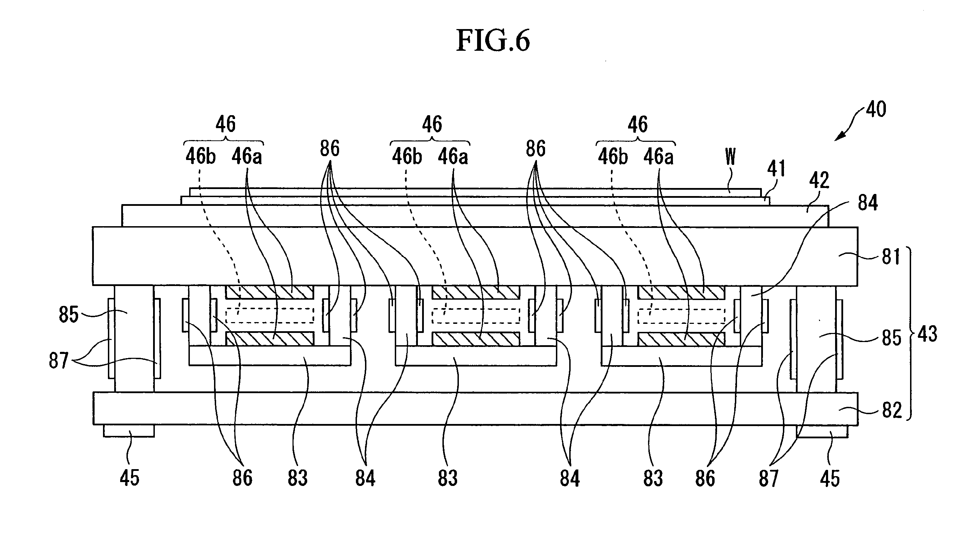

Further, as shown in FIG. 6, even if movers 46a of a plurality of driving parts 46 are coupled to the XY table 43 through the coupling members 84, a plurality of piezoelectric actuators 86 have only to be fixed to each of the coupling members 84 Then, the piezoelectric actuators 86 are selectively driven depending on the direction of the driving force F applied to the XY table 43 so that the generation of internal vibration can be prevented in each moving direction.

The present invention is also applicable to a twin-stage type exposure apparatus described, for example, in Japanese Patent Application Laid-Open Nos. 10-163099, 10-214783 and US Patent No. 6,400,441 corresponding thereto, Published Japanese translation of PCT International Publication for Patent Application No. 2000-505958 and US Patent No. 5,969,441. corresponding thereto, and US Patent No. 6,262,796. The disclosure of the above publications and US Patents are incorporated herein as part of this specification within a range of permission of the domestic laws and ordinances of the countries designated (or selected) in this international application.
The present invention is further applicable to an exposure apparatus, as disclosed in Japanese Patent Application Laid Open No. 11-135400, which includes an exposure stag movable while holding a substrate to be processed such as a wafer thereon, and a measurement stage equipped with various measuring members and sensors. The disclosure of the above publication and a corresponding US Patent is incorporated herein as part of this specification within a range of permission of the domestic laws and ordinances of the countries designated (or selected) in this international application.
In the foregoing embodiment, a light-transmitting mask with a predetermined light-shielding pattern (or phase pattern or light-reducing pattern) formed on a light-transmitting substrate, or a light-reflecting mask with a predetermined reflection pattern formed on a light-reflecting substrate is used, but the present invention is not limited thereto. For example, instead of such' a mask, an electronic mask (as part of an optical system) may be used, which forms a transmission pattern, a reflection pattern, or a luminous pattern based on electronic data of the pattern to be exposed. Such an electronic mask is disclosed, for example, in US Patent No. 6,778,257. The disclosure of the above US Patent is incorporated herein as part of this specification within a range of permission of the domestic laws and ordinances of-the countries designated (or selected) in this international application. Note that the electronic mask is a concept including both a non-luminous type image display element and a self-luminous type image display element.
Furthermore, the present invention is applicable to an exposure apparatus for exposing, onto a substrate, interference fringes caused by a plurality of light beams interfering with one another, for example, an exposure apparatus for performing so-called two-beam interference exposure. Such an exposure method and exposure apparatus is disclosed, for example, in International Publication No. WO 01/35168. The disclosure of the above US patent and publication are each hereby incorporated by reference in its entirety to the extent permitted the national laws and regulations of designated states (or selected states) designated by the present international patent application.

Further, in the foregoing embodiment, although the description is made of the exposure apparatus in which a gas (air or nitrogen) is filled between the projection optical system and the wafer, the present invention is also applicable to an immersion type exposure apparatus.
Such an immersion exposure apparatus is disclosed, for example, in International Publication No. WO 2004/053958, in which liquid is locally filled between the projection optical system 30 and the substrate W. The disclosure of the above pamphlet is incorporated herein as - part of this specification within a range of permission of the domestic laws and ordinances of the countries designated (or selected) in this international application.
Further, the present invention is applicable to an immersion exposure apparat-us in which a stage holding a substrate to be exposed is moved in a liquid bath, or an immersion exposure apparatus in which a liquid bath is formed to a predetermined depth on a stage so that a substrate will be held in the liquid bath. The structure of the immersion exposure apparatus in which the stage holding the substrate to be exposed is moved in the liquid bath and its exposure operation are disclosed, for example in Japanese Patent Application Laid-Open No. 06-124873, and the immersion exposure apparatus in which the liquid bath is formed to a predetermined depth on the stage so that the substrate will be held in the liquid bath is disclosed, for example, in Japanese Patent Application Laid-Open No. 10-303114 and US Patent No. 5,825,043. The disclosure of the above US patent and publication are each hereby incorporated by reference in its entirety to the extent permitted the national laws and regulations of designated states (or selected states) designated by the present international patent application.
Further, the present invention is not limited to the structure of filling a liquid (pure water) in an optical path space on the irradiation side of an end optical member of the projection optical system 30 to expose a substrate W (wafer). As disclosed in International Publication No. WO 2004/019128, the liquid (pure water) may also be filled in an optical path space on the incidence side of the end optical member of the projection optical system 30. The disclosure of the above US patent and publication are each hereby incorporated by reference in its entirety to the extent permitted the national laws and regulations of designated states (or selected states) designated by the present international patent application.

Further, in the foregoing embodiment, the step-and-scan type exposure apparatus is taken as an example, but the present invention is also be applicable to a step and-repeat type exposure apparatus. Further, in addition to the exposure apparatus used in manufacturing semiconductor devices, the present invention is applicable to an exposure apparatus used in manufacturing displays including liquid crystal display devices (LCDs), which transfers a device pattern onto a glass plate, an exposure apparatus used in manufacturing thin-film magnetic heads, which transfers a device pattern onto a ceramic wafer, an exposure apparatus used in manufacturing image pickup devices such as CCDs, etc. Furthermore, the present invention is applicable to an exposure apparatus for transferring a circuit pattern to a glass substrate, a silicon wafer, or the like to manufacture a- reticle or mask used in a photoexposure apparatus, an EUV exposure apparatus, an X-ray exposure apparatus, an electron-beam exposure apparatus, etc. Here, in case of an exposure apparatus using DUV (far ultraviolet) light or VUV (vacuum ultraviolet) light, a transmission-type reticle is typically used, and quartz glass, quartz glass doped with fluorine, fluorite, magnesium fluoride, quartz crystal, or the like is used as the reticle substrate. Further, in case of an x-ray exposure apparatus or an electron-beam exposure apparatus based on a proximity system, a transmission mask (stencil mask or membrane mask) is used, and a silicon wafer or the like is used as the mask substrate.

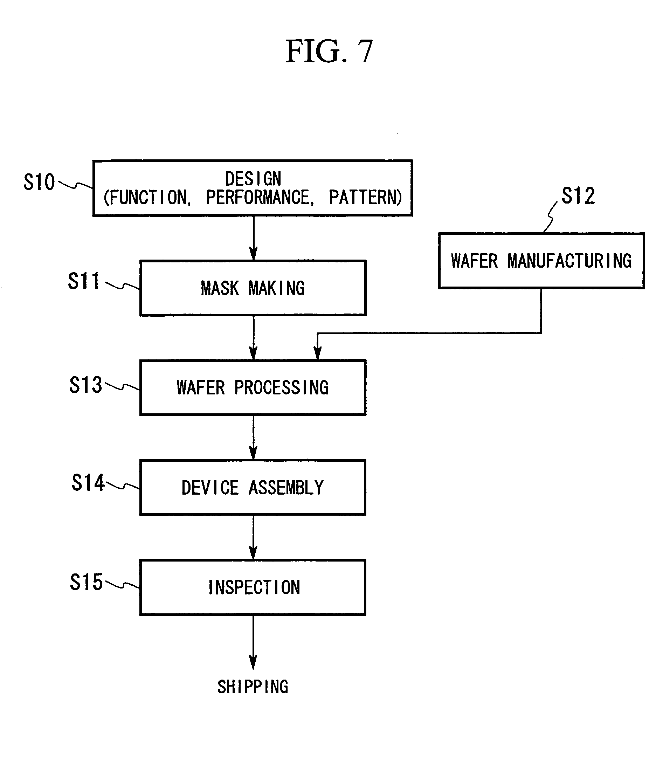

The following describes an embodiment of a microdevice manufacturing method using the exposure apparatus and exposure method according to the embodiment of the present invention in a lithography process. FIG. 7 is a flowchart illustrating an example of manufacturing a microdevice (a semiconductor chip such as an IC or LSI, a liquid crystal panel, a CCD, a thin magnetic head, a micromachine, or the like). As shown in FIG. 7, first in step S10 (design step), function/performance is designed for a microdevice (e.g., circuit design for a semiconductor device, etc.), and a pattern to implement the function is designed. Then, in step S11 (mask making step), a mask (reticle) on which the designed circuit pattern is formed is made. On the other hand, in step S12 (wafer manufacturing step), a wafer is manufactured using a material such as silicon.

Next, in step 13 (wafer processing step), an actual circuit or the like is formed on the wafer by lithography using the mask and the wafer prepared in steps S10 to S12 in a manner to be described later. Next, in step S14 (device assembly step), a device is assembled using the wafer processed in step S13. This step S14 includes processes such as dicing, bonding, packaging (chip encapsulation), etc. as required. Finally, in step S15 (inspection step), tests on operation, durability, and so on are performed on the device made in step S14. After these steps, the microdevice is completed and shipped.

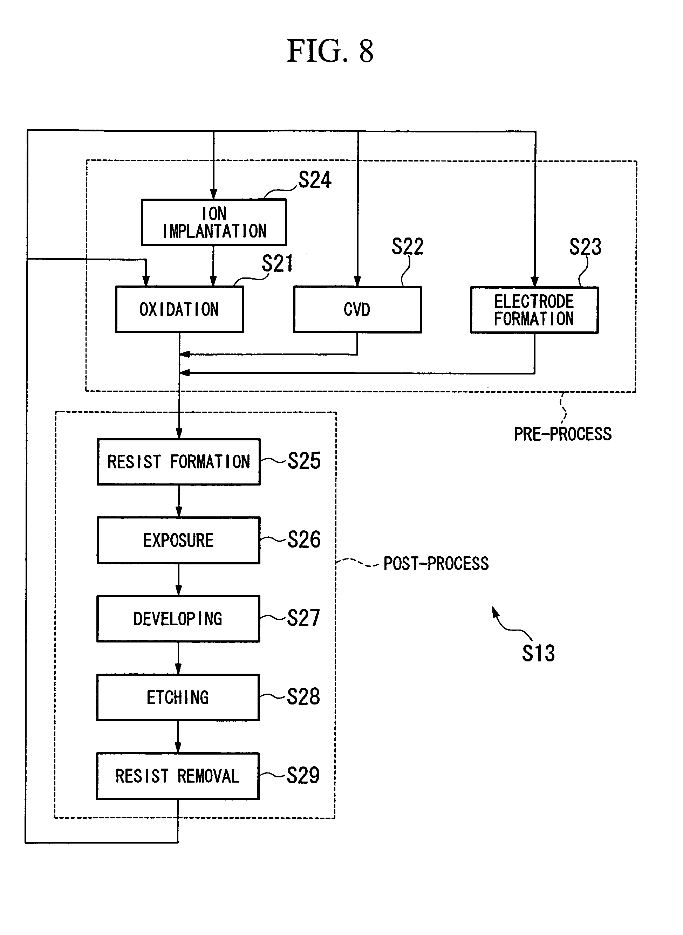

FIG. 8 illustrates an example of a detailed process of step S13 in case of manufacturing a semiconductor device.
In step S21 (oxidation-step), the surface of the wafer is oxidized. In step S22 (CVD step), an isolating film is formed on the wafer surface. In step S23 (electrode formation step), an electrode is formed on the wafer by vapor deposition. In step S24 (ion implantation step), ions are implanted into the wafer. Steps S21 to S24 described above constitute a pre-process for the respective steps in wafer processing, and are selectively performed in accordance with processing required in each step.

After completion of the above pre-process in the respective steps in the wafer process, a post-process is performed as follows: In this post-process, first in step S25 (resist formation step), a photosensitive agent is applied onto the wafer. Then, in step S26 (exposure step), the circuit pattern on the mask is transferred onto the wafer using the above-mentioned lithography system (exposure apparatus) and the exposure method. Next, in step S27 (developing step), the exposed wafer is developed, and in step S28 (etching step), exposed portions other than those on which the resist remains are removed by etching. Then, in step S29 (resist removing step), the resist unnecessary after the etching is completed is removed. By repeating these pre-process and post-process steps, circuit patterns are formed one upon another on the wafer in a superimposed manner.

In addition to the microdevice such as the semiconductor device, in order to manufacture a reticle or mask used in a photoexposure apparatus, an EUV exposure apparatus, an X-ray exposure apparatus, an electron-beam exposure apparatus, etc. , the-present invention is applicable to an exposure apparatus for transferring a circuit pattern from a mother reticle to a glass substrate, a silicon wafer, or the like. In case of an exposure apparatus using DUV (far ultraviolet) light or VUV (vacuum ultraviolet) light, a transmission type reticle is typically used, and quartz glass, quartz glass doped with fluorine, fluorite, magnesium fluoride, quartz crystal, or the like is used as the reticle substrate. Further, in case of an x-ray exposure apparatus or an electron-beam exposure apparatus based on a proximity system, a transmission mask (stencil mask or membrane mask) is used, and a silicon wafer or the like is used as the mask substrate. Such an exposure apparatus is disclosed in International Publication Nos. WO 99/34255, 99/50712, and 99/66370, and Japanese Patent Application Laid-Open Nos 11-194479, 2000-12453, and 2000-29202. The disclosure of the above US patent and publication are each hereby incorporated by reference in its entirety to the extent permitted the national laws and regulations of designated states (or selected states) designated by the present international patent application.

## Claims

1. An aligning apparatus including a table part with an aligning target object placed thereon and movable at least in a uniaxial direction , a driving part that applies a driving force to the table part in the uniaxial direction, and a position measuring part that measures a position in the uniaxial direction of the table part, wherein
the table part comprises actuators, provided in one or more among somewhere between two points, one being a point of application of force at which the driving force is applied and the other being an aligning target point upon which the aligning target object is placed, somewhere between two points, one being a point to be measured by the position measuring part and the other being the aligning target point, and somewhere between two points, one being the point of application of force and the other being the measured point, to maintain relative positions between the respective two points substantially constant.

2. The aligning apparatus according to claim 1, wherein the table part comprises an actuator that maintains a relative position between two points, one being a predetermined member in the table part and the other being the point of application of force, substantially constant.

3. The aligning apparatus according to claim 1 or 2, wherein the actuators are driven upon acceleration and/or deceleration of the table part.

4. The aligning apparatus according to any one of claims 1 to 3, wherein the actuators provide a change in rigidity between the two points, respectively.

5. The aligning apparatus according to any one of claims 1 to 4, wherein the actuators exert a predetermined force between the two points, respectively.

6. The aligning apparatus according to any one of claims 1 to 4, wherein the actuators themselves construct at least one of the respective distances between the two points.

7. The aligning apparatus according to any one of claims 1 to 6, wherein the actuators are piezoelectric actuators.

8. An aligning method that places an aligning target object on a table part movable at least in a uniaxial direction and measuring a position in the uniaxial direction of the table part-while applying a driving force to the table-part in the uniaxial direction to move the aligning target object to a predetermined position,
wherein upon acceleration and/or deceleration of the table part,
one or more relative positions between two points, one being a point of application of force of the table part at which the driving force is applied and the other being an aligning target point upon which the aligning target object is placed, between two points, one being a point in the table part to be measured by a position measuring part and the other being the aligning target point, and between two points, one being the point of application of force and the other being the measured point, are maintained substantially constant.

9. The aligning method according to claim 8, wherein the relative position between two points, one being a predetermined member in the table part and the other being the point of application of force, is maintained substantially constant concurrently.

10. The aligning method according to claim 8 or 9, wherein rigidity between the two points is changed.

11. The aligning method according to any one of claims 8 to 10, wherein a predetermine force is exerted between the two points.

12. An exposure apparatus, including a mask stage that holds a mask and a substrate stage that holds a substrate, that exposes a pattern formed on the mask onto the substrate,
wherein the aligning apparatus according to any one of claims 1 to 7 is used for at least either of the mask stage and the substrate stage.

13. An exposure apparatus that forms a predetermined pattern on a substrate,
wherein the aligning apparatus according to any one of claims 1 to 7 is used for aligning the substrate.

14. The exposure apparatus according to claim 12 or 13,
wherein the exposure apparatus is a scanning type exposure apparatus for irradiating exposure light to the substrate while moving the substrate, and the exposure light is irradiated to the substrate during at least either acceleration or deceleration of the substrate.

15. An exposure method that aligns a mask placed on a mask stage and a substrate placed on a substrate stage to each other to expose a pattern formed on the mask onto the substrate,
wherein the aligning method according to any one of claims 8 to 11 is used as at least either of an aligning method for the mask and an aligning method for the substrate.

16. An exposure method that forms a predetermined pattern on a substrate,
wherein the aligning method according to any one of claims 8 to 11 is used for aligning the substrate.

17. The exposure method according to claim 15 or 16,
wherein the exposure method is a scanning type exposure method for irradiating exposure light to the substrate while moving the substrate, and the exposure light is irradiated to the substrate during at least either acceleration or deceleration of the substrate.

18. A device manufacturing method including a lithography process, wherein the exposure apparatus according to any one of claims 12 to 14 or the exposure method according,to any one of claims 15 to 17 is used in the lithography process.

19. An aligning apparatus including a table part that places an object thereon and a drive unit that moves the table part,
wherein the relative position between a point of application of force of the table part at which a driving force of the drive unit is applied and an aligning target point in the object is maintained substantially constant.

20. The aligning apparatus according to claim 18 further comprising an actuator that exerts a predetermined force between the point of application of force and the aligning target point depending on the driving force generated by the drive unit.

21. An exposure apparatus that forms a predetermined pattern on a substrate,
wherein the aligning apparatus according to claim 19 is used for aligning the substrate.

22. An aligning method for placing an object on a table part and moving the table part by means of a drive unit,
wherein the relative position between a point of application of force of the table part at which a driving force of the drive unit is applied and an aligning target point in the object is maintained substantially constant.

23. The aligning method according to claim 22, wherein a predetermined force is exerted between the point of application of force and the aligning target point in addition to the driving force depending on the driving force generated by the drive unit.

24. An exposure method that forms a predetermined pattern on a substrate,
wherein the aligning method according to claim 22 is used for aligning the substrate.

25. A device manufacturing method including a lithography process, wherein the exposure apparatus according to claim 21 or the exposure method according to claim 24 is used in the lithography process.
